# EUROPEAN PATENT APPLICATION

(11) **EP 0 560 531 A1**
(43) Date of publication of application: **15.09.1993**
(21) Application number: 93301594.3
(22) Date of filing: 03.03.1993
(51) Int. Cl.: H01L 27/12, G02F 1/136

(54) **Method for manufacturing a liquid crystal display device**

(30) Priority: 11.03.1992 GB 9205278
(71) Applicant: GEC-MARCONI LIMITED, Stanmore, Middlesex HA7 4LY (GB)
(72) Inventor: Haws, Stephen Anthony, St. Albans, Hertfordshire AL3 4QW (GB)
(74) Representative: Cockayne, Gillian

(57) **Abstract**

s7 A method of fabricating a layered backplane structure for a liquid crystal display includes the steps of forming a first layer of polysilicon on a substrate (1) and patterning the first polysilicon layer (5,7,9,11,13) using a first masking and etching process. A dielectric layer is deposited over the patterned first polysilicon layer, and a metal layer is deposited over the dielectric layer. The metal layer is patterned (15,17,19,21,23,25) using a second masking and etching process. A passivating layer is deposited over the metal layer. A patterned third masking layer is provided over the passivating layer,and the passivating layer is patterned using the third masking layer. An electrically-conductive layer is deposited over the third masking layer, and the conductive layer is patterned (41,43,45,47) by removing the third masking layer with unwanted portions of the conductive layer attached thereto.

## Description

This invention relates to display devices, and particularly to liquid crystal display matrices which employ an active cell-switching device at each pixel.

Active matrix displays employ such electrically- active elements at each pixel in order to effect better switching speed, better contrast and larger viewing angle than is achievable with simple multiplexed displays. There are various technologies for implementing active matrix displays and these vary in terms of the overall display performance they offer and the complexity, and therefore the cost, of manufacture. Simple technologies, such as those based on Metal Insulator Metal (MIM) devices, are very attractive for applications such as alphagraphic computer displays, since they can be accomplished with as few as two masking levels. However, there are various limitations associated with these simpler technologies which make them unsuitable for larger displays, which also require fine resolution and video speed capability.

It is therefore necessary to employ more complex technologies based on, for example, amorphous silicon diodes, amorphous silicon thin film transistors and polysilicon thin film transistors. Such technologies sufferfrom the disadvantage of requiring at least four masking levels for manufacture of the display backplane, and even six or eight levels for displays larger than about 15cms x 15cms. Due to theiroverall complexity and the fact that they use double-layer metal structures, the yield of displays manufactured by such processes is low.

The use of polysilicon technology has advantages over the use of other technologies, and in particular over amorphous silicon thin film transistor technology, in that polysilicon devices are more stable when subjected to heatand/orlight, and greater yields and better performance are achievable, due to the provision of the very small, self-aligned active elements which can be provided by virtue of the high electrical mobility and the type of processing techniques, such as ion implantation, which are applicable to the polysilicon material.

The use of polysilicon technology therefore offers advantages in the manufacture of, for example, large high-resolution computer displays. However, the known polysilicon manufacturing processes involve the use of six to eight masking levels during the manufacture of a display.

For example, the display architecture described in our British patent Application No. 8926960.9 enables very much higher fabrication yields to be achieved, by eliminating metal cross-overs and by preventing a gate fault in a pixel drive transistor from affecting other pixels. However, the existing processes for implementing the fabrication have the above-mentioned disadvantage of requiring six to eight masking levels.

It is an object of the present invention to provide an improved display fabrication method which involves fewer masking levels.

According to one aspect of the invention there is provided a method of fabricating a patterned layer structure, wherein a first layer supported by a substrate is patterned by use of a patterned layer of masking material located over said first layer; a second layer is deposited on the layer of masking material; and the second layer is patterned by removal of the layer of masking material with unwanted portions of the second layer attached thereto.

According to another aspect of the invention there is provided a method of fabricating a layered backplane structure for liquid crystal display, including the steps of forming a first layer of polysilicon on a substrate; patterning the first polysilicon layer using a first masking and etching process; depositing a dielectric layer over the first polysilicon layer; depositing a metal layer over the dielectric layer; patterning the metal layer using a second masking and etching process; depositing a passivating layer over the metal layer; providing a patterned third masking layer over the passivating layer; patterning the passivating layer using the third masking layer; depositing an electrically-conductive layer over the third masking layer; and patterning the conductive layer by removing the third masking layer with unwanted portions of the conductive layer attached thereto.

An embodiment of the invention will now be described, by way of example, with reference to the accompanying drawings, in which
Figures 1-5 are schematic plan views showing successive stages in the fabrication of a portion of a liquid crystal display,
Figure 6 is an enlarged view of part of Figure 5, and
Figures 7-9 are schematic plan views showing stages in an alternative fabrication process.

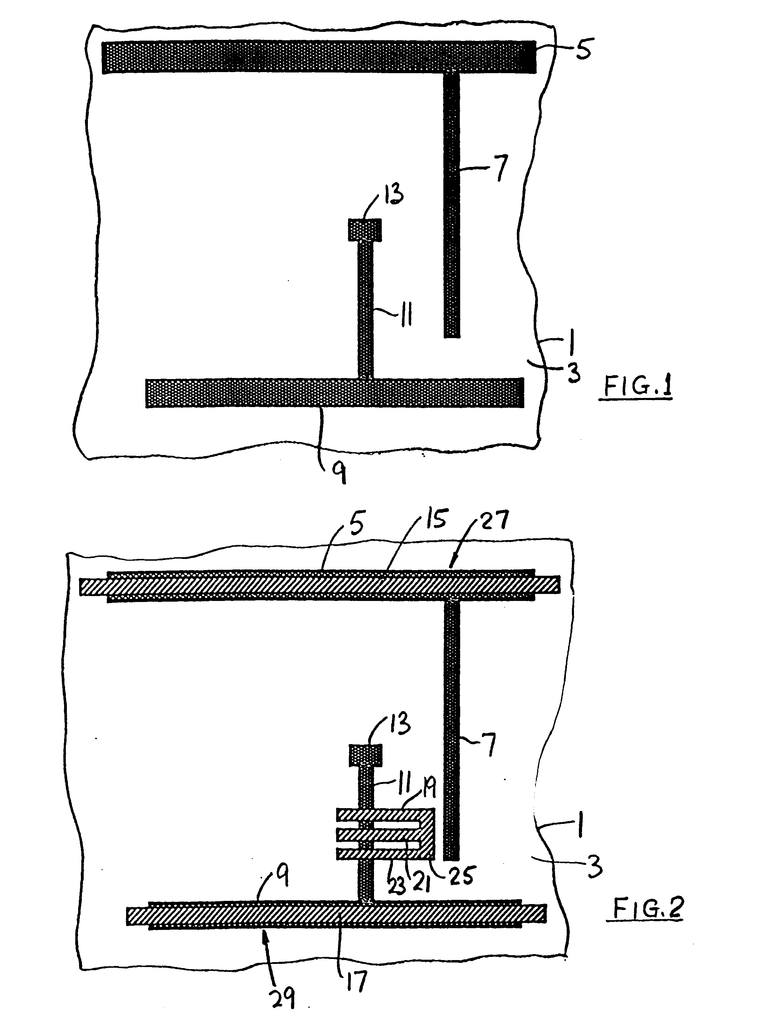

Referring to Figure 1 of the drawings, a substrate 1 formed of glass or other suitable transparent material is cleaned and annealed, and a layer 3 of a barrier material, such as silicon dioxide, is deposited thereover by, for example, chemical vapour deposition.

A layer of polysilicon is then deposited on the layer 3. The polysilicon may be deposited by a process and using an apparatus such as described in our British patent Applications Nos. 2,193,976 and 2,213,835. The polysilicon layer is then enhanced by depositing a layer of silicon dioxide thereon, preferably by a chemical vapour deposition process, and annealing the device in oxygen, or in a non-reactive gas, at a temperature of at least 595°C for a period of up to 48 hours. The silicon dioxide layer is then removed.

The polysilicon layer is then patterned by conventional photo-etching techniques, using a first mask. The photo-etching process results in polysilicon regions 5,7,9,11 and 13 remaining, but the rest of the polysilicon layer removed.

A gate dielectric layer is then deposited or grown over the polysilicon regions. The layer may be, forex- ample, 800-1200A thick, and is preferably formed of silicon dioxide. The silicon dioxide may be densified, before the next process step by, for example, using a suitable thermal annealing process.

A metal layer, for example of thickness 3000A to 1.0µm, is then deposited over the existing layers and is patterned by a photo-etch process, using a second mask. Metal portions 15,17,19,21,23 and 25 (Figure 2) are left when the process has been completed, the remainder of the metal layer having been removed. The portions 19,21 and 23 form transistor gate electrodes, and the portions 15 and 17 provide the main current-carrying capability for tracks 27 and 29, which also include the polysilicon regions 5 and 9. The metal layer may be formed of, for example, a refractory material such as chromium, tantalum, molybdenum, tungsten or titanium. Alternatively, the proposed metal-only layer may be replaced by a thin polysilicon layer (e.g. less than 250A thick) followed by a layer of any of the above-mentioned metals. The polysilicon layer will interface with the underlying gate dielectric layer and thereby improve the performance of the completed device.

The areas of polysilicon which are not protected by the metal portions 15-25 are then ion implanted with a suitable dopant, such as phosphorus. This step may be improved by retaining the resist employed during the previous patterning step so that the resist prevents implantation of phosphorus in the metal portions. Any remaining resist material is then removed, and the device is annealed at a temperature for example in excess of 580°C for at least 5 hours in a nitrogen atmosphere.

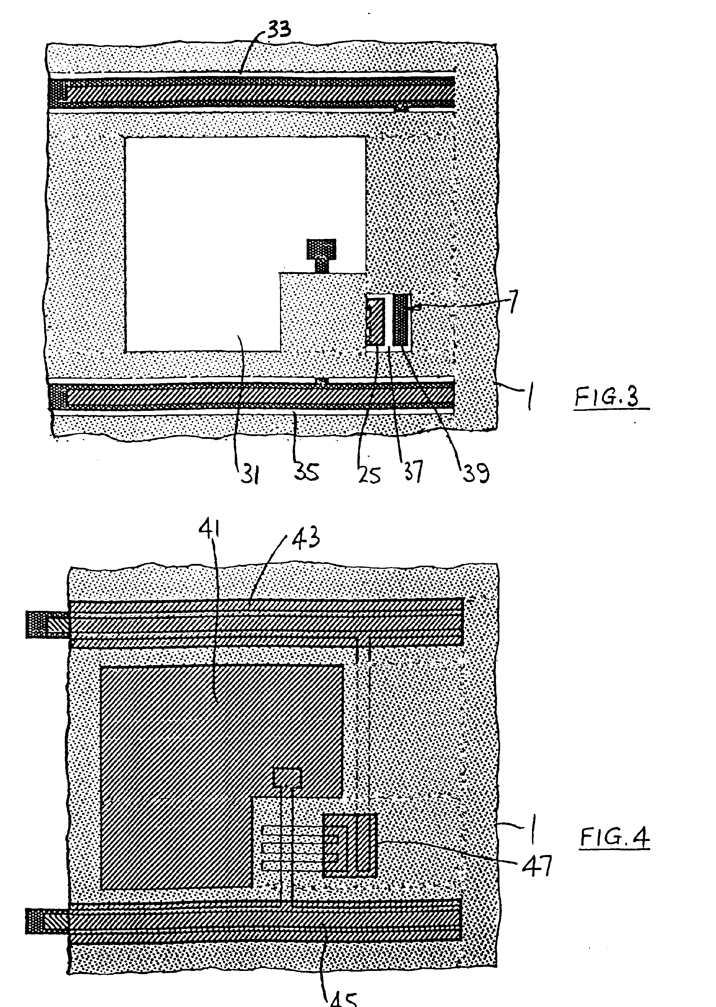

An electrically-passivating layer is then deposited overall. This layer may be of, for example, silicon nitride. A third mask is used in patterning the silicon nitride layer. This mask is preferably formed of polyimide, which may be photosensitive or may itself be patterned with an overlay of other photolithographic resist material. Other masking materials may be used, provided that they fulfil the requirements of (a) high-temperature stability (e.g. 350 - 450°C), (b) absence of contamination of semiconductor materials, and (c) the ability to be lifted off in a subsequent processing step. The silicon nitride and the underlying gate dielectric layer are then etched, preferably using a dry etching technique, to uncoveran area 31 (Figure 3) on which a layer of indium tin oxide is to be deposited in a later process step, areas 33 and 35 at the positions of the tracks 27 and 29, and an area 37 around the metal layer portion 25 and around the free end 39 of the polysilicon layer portion 7. Any remaining resist material is then removed, but the patterned polyimide masking layer is retained intact.

A thin layer of metal is then deposited over the whole of the substrate. The metal layer is preferably a layer of pure aluminium and is, for example, 100-500A thick. It may be deposited by, for example, an evaporation process or a sputtering process. Alternatively the layer may be formed of an aluminium/silicon alloy. The device is then annealed at a temperature in the range 350-450°C, and for a period from ¹/₂ hour to many hours depending on the characteristics required for the device. The annealing process serves to dope the exposed silicon areas with aluminium to ensure that those areas make good electrical contact with an indium tin oxide film which is to be deposited thereover. The annealing process also causes hydrogenation of the thin film transistor device by hydrogen evolved from the silicon nitride film. The hydrogen is incorporated in the silicon nitride film during the plasma-assisted chemical vapour deposition process, which employs gases containing hydrogen. The hydrogen is driven out of the film due to the heating above 350°C. Any unalloyed aluminium is then removed using a blanket wet or dry etching technique.

Referring to Figure 4, a film of indium tin oxide is then deposited over the layer structure. This film is then patterned by a lift-off process in which those parts of the indium tin oxide film which are deposited on the polyimide regions come off with the polyimide, leaving indium tin oxide regions 41,43,45 and 47 covering the regions 31,33, 35 and 37, respectively. The removal of the polyimide regions may be carried out most effectively using fuming nitric acid in an ultrasonic bath. Asolution flow and filtering system should preferably be used forthe polyimide removal process to prevent any fragments of polyimide and indium tin oxide from becoming re-deposited on the structure. The lift-off process described benefits from the inherent relatively poor adhesion between the silicon nitride and the polyimide. Alternative resist materials and lift-off solutions, including organic materials, may be used.

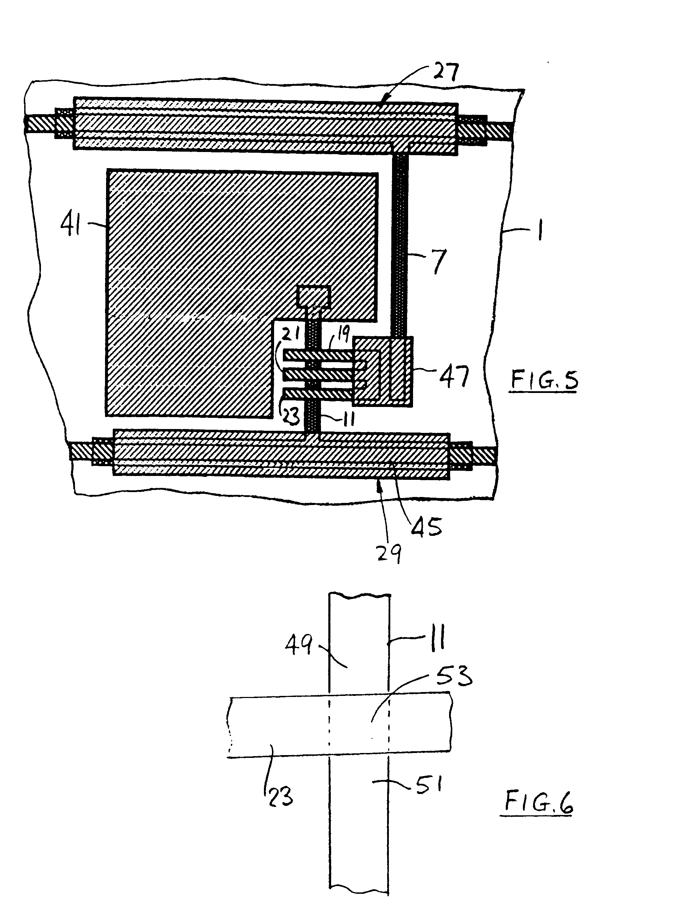

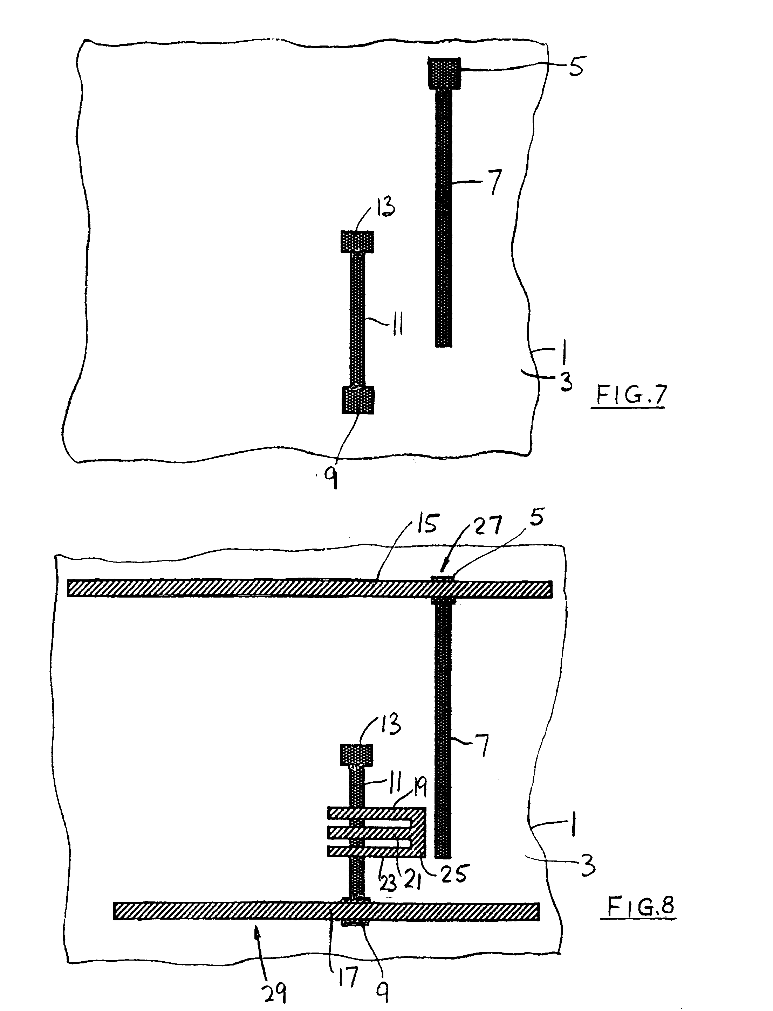

The indium tin oxide region 41 forms one electrode of a liquid crystal pixel when the substrate and a top plate (not shown) are assembled together, with liquid crystal material filling a gap therebetween. It also provides a connection to the polysilicon channel region 11. The regions 43 and 45 provide contacts for the tracks 27 and 29, respectively, and the region 7 interconnects the metal gate electrodes 19,21,23, 25 and the polysilicon gate conductor 7. The latter conductor is of relatively high resistance, and will prevent a gate short-circuit from having any appreciable effect on the drive voltages applied to other pixels connected to the tracks 27 and 29. The metal portions 19,21 and 23, interconnected by the portion 25, divide the polysilicon channel region 11 into source and drain segments of thin film transistors which are effectively in series. The portions 19,21 and 23 act as gate electrodes for the transistors. Although three of these metal portions are shown, all of the same width, any suitable number of metal strips may be provided, and they may be of equal or unequal widths. Figure 5 is a schematic plan view of the completed portion of a display backplane and Figure 6 shows an enlarged view of source and drain electrodes 49,51 and a gate electrode 53 of the transistor.

The tracks 27 and 29 can serve to supply both "reference" and "gate" signals to the pixels at different times during display address cycles. The design avoids any crossing of tracks on the substrate, and the required data signals are applied to the pixels via patterned tracks on the top plate. The polysilicon regions 5,9 and the indium tin oxide regions 43,45 provide redundancy in the event of a break in the metal track portions 15,17 during fabrication.

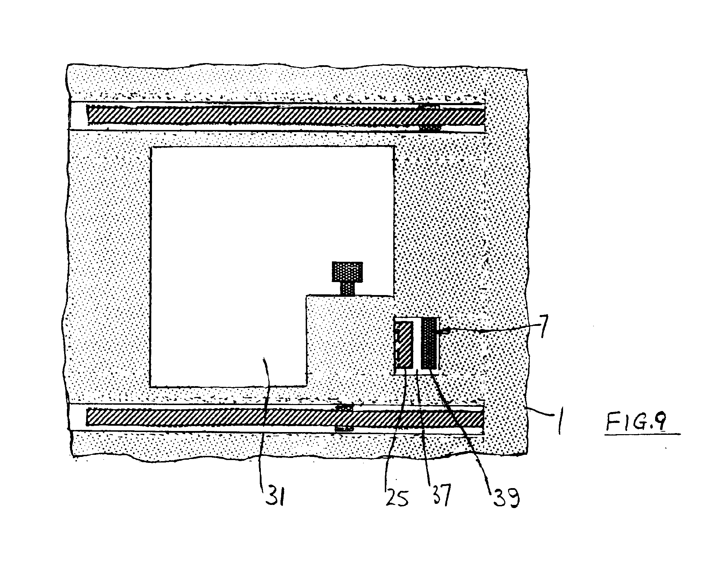

An alternative configuration which increases the area available for the optically-active pixel area 41 at the expense of some of the redundancy is shown in Figures 7-9. The polysilicon track regions 5 and 9 are omitted, so the indium tin oxide regions 43,45 no longer have to overlap those polysilicon regions. The regions 43,45 can therefore be made narrower, and the region 41 wider.

An alternative passivation material might be employed, such as silicon dioxide deposited by chemical vapour deposition. The hydrogenation might then be omitted, or might be effected by a different technique, such as plasma hydrogenation.

A substantially optically opaque patterned layer ("black matrix") is provided between the optically active pixel areas to block unwanted light transmission in the completed display device. Using the backplane configuration described above, the black matrix layer is provided on the top plate. This minimises the complexity of the backplane. However, the black matrix could be provided in the backplane by using a black passivation material. The black layer may be patterned in-situ with a silicon nitride film, thereby retaining a relatively thick and effective passivation and hydrogenating film. The black material might be a carbon film deposited by chemical vapour deposition.

The invention makes possible the production of a backplane using only three masking stages, namely for the patterning of the polysilicon layer, the patterning of the metal layer and the patterning of the silicon nitride layer. The required patterning of the indium tin oxide layer is effected, without further masking, by using a lift-off technique employing the already-patterned polyimide layer.

## Claims

1. A method of fabricating a patterned layer structure, characterised in that a first layer supported by a substrate (1) is patterned by use of a patterned layer of masking material located over said first layer; a second layer is deposited on the layer of masking material; and the second layer is patterned (41,43,45,47) by removal of the layer of masking material with unwanted portions of the second layer attached thereto.

2. A method of fabricating a layered backplane structure for a liquid crystal display, characterised by the steps of forming a first layer of polysilicon on a substrate (1); patterning the first polysilicon layer (5,7,9,11,13) using a first masking and etching process; depositing a dielectric layer over the first polysilicon layer; depositing a metal layer over the dielectric layer; patterning the metal layer (15,17,19,21,23,25) using a second masking and etching process; depositing a passivating layer over the metal layer; providing a patterned third masking layer over the passivating layer; patterning the passivating layer using the third masking layer; depositing an electrically-conductive layer over the third masking layer; and patterning the conductive layer (41,43,45,47) by removing the third masking lay- erwith unwanted portions of the conductive layer attached thereto.

3. A method as claimed in Claim 2, characterised in that the passivation material is annealed before deposition of the conductive layer, and the annealing causes evolution of hydrogen for hydrogenation of the polysilicon layer.

4. A method as claimed in Claim 3, characterised in that the passivation material is silicon nitride.

5. A method as claimed in any one of Claims 2-4, characterised in that the patterned first polysilicon layer (5,7,9,11,13) provides a channel (11) and source (49) and drain (51) regions of a thin film transistor.

6. A method as claimed in Claim 5, characterised in that the patterned first polysilicon layer (5,7,9,11,13) also provides a resistive connection to a gate electrode (53) of the transistor.

7. A method as claimed in Claim 5 or Claim 6, characterised in that the metal layer provides a gate electrode for the transistor.

8. A method as claimed in any one of Claims 5-7, characterised in that the metal layer is formed of a refractory material or combination of materials.

9. A method as claimed in any one of Claims 2-8, characterised in that the metal layer is combined with a second polysilicon layer.

10. A method as claimed in any one of Claims 2-9, characterised in that after deposition and patterning (15-25) of the metal layer, exposed areas of the first polysilicon layer are doped with a dopant material by ion implantation.

11. A method as claimed in any one of Claims 2-10, characterised in that after deposition and patterning of the passivation layer a second layer of metal is deposited over the passivation layer and is annealed to dope exposed areas of the first polysilicon layer with the metal of said second metal layer.

12. A method as claimed in Claim 11, characterised in that the second layer of metal is formed of aluminium.

13. A method as claimed in any one of Claims 2-12, characterised in that the electrically-conductive layer is formed of indium tin oxide.

14. A method as claimed in any one of Claims 2-13, characterised in that the third masking layer is formed of polyimide.

15. A method as claimed in any one of Claims 2-14, characterised in that a layer of black matrix material is formed beneath, or instead of, the passivating layer.
